# EUROPEAN PATENT APPLICATION

(11) **EP 2 713 404 A2**
(43) Date of publication of application: **02.04.2014**
(21) Application number: 13184091.0
(22) Date of filing: 12.09.2013
(51) Int. Cl.: H01L 31/032, H01L 31/068

(54) **Photoelectric conversion element and solar cell**

(30) Priority: 26.09.2012 JP 2012212255; 26.09.2012 JP 2012212256; 31.07.2013 JP 2013158799
(71) Applicant: Kabushiki Kaisha Toshiba, Tokyo 105-8001 (JP)
(72) Inventor: Shibasaki, Soichiro, Tokyo, 105-8001 (JP); Hiraga, Hiroki, Tokyo, 105-8001 (JP); Nakagawa, Naoyuki, Tokyo, 105-8001 (JP); Yamazaki, Mutsuki, Tokyo, 105-8001 (JP); Yamamoto, Kazushige, Tokyo, 105-8001 (JP); Sakurada, Shinya, Tokyo, 105-8001 (JP); Inaba, Michihiko, Tokyo, 105-8001 (JP)
(74) Representative: HOFFMANN EITLE

(57) **Abstract**

A photoelectric conversion element includes a photoelectric conversion layer, a transparent electrode, an intermediate layer, and a window layer. The photoelectric conversion layer includes a homojunction of a p-type compound semiconductor layer and an n-type compound semiconductor layer. The p-type and n-type compound semiconductors include group I-III-VI₂ compound or group I₂-II-IV-VI₄ compound. The intermediate layer is provided between the n-type compound semiconductor layer and the transparent electrode. The intermediate layer is 1 nm to 10 nm in thickness. The window layer is provided between the intermediate layer and the transparent electrode.

## Description

### CROSS REFERENCE TO RELATED APPLICATION

This application is based upon and claims the benefit of priority from Japanese Patent Applications No. 2012-212255, filed on September 26, 2012, No. 2012-212256, filed on September 26, 2012 and No. 2013-158799 July 31, 2013; the entire contents of which are incorporated herein by reference.

### FIELD

Embodiments described herein relate generally to a photoelectric conversion element and a solar cell.

### BACKGROUND

A solar cells use a photoelectric conversion element of compound semiconductor films, and easily develop site defects in the photoelectric conversion element when manufactured. The site defects serve as recombination centers to prevent enhancement of photoelectric conversion efficiency. In principle, solar cells having lattice-matched homojunction should have higher conversion efficiency than solar cells having lattice-mismatched heterojunction. Unfortunately, the solar cells having homojunction have very low conversion efficiency because of their low open voltage in some cases.

### BRIEF DESCRIPTION OF THE DRAWINGS

FIG. 1 is a conceptual diagram showing a photoelectric conversion element in accordance with a first embodiment.

Fig. 2 is a conceptual diagram showing a photoelectric conversion element in accordance with a second embodiment.

Fig. 3 is a conceptual diagram showing a photoelectric conversion element in accordance with a third embodiment.

Fig. 4 is a depth profile of S by a SIMS analysis conducted on a photoelectric conversion element of an example.

Fig. 5 is a graph showing changes in conversion efficiency of solar cells of various junction types.

Fig. 6 is a photoelectric conversion element of an example.

### DETAILED DESCRIPTION

A photoelectric conversion element of an embodiment includes a photoelectric conversion layer, a transparent electrode, an intermediate layer, and a window layer. The photoelectric conversion layer includes a homojunction of a p-type compound semiconductor layer and an n-type compound semiconductor layer. The p-type and n-type compound semiconductors include group I-III-VI₂ compound or group I₂-II-IV-VI₄ compound. The intermediate layer is provided between the n-type compound semiconductor layer and the transparent electrode. The intermediate layer is 1 nm to 10 nm in thickness. The window layer is provided between the intermediate layer and the transparent electrode.

According to another embodiment, a photoelectric conversion element includes a photoelectric conversion layer and a transparent electrode. The photoelectric conversion layer has a homojunction of a p-type compound semiconductor layer and an n-type compound semiconductor layer. The p-type and n-type compound semiconductors include group I-III-VI₂ compound or group I₂-II-IV-VI₄ compound. The group I-III-VI₂ compound or the group I₂-II-IV-VI₄ compound includes Se as a group VI element. The transparent electrode is provided on the n-type compound semiconductor layer. In addition, the n-type compound semiconductor layer includes a region doped with S on a side of the transparent electrode.

According to another embodiment, a photoelectric conversion element includes a photoelectric conversion layer, an intermediate layer, and a transparent electrode on the intermediate layer. The photoelectric conversion layer has a homojunction of a p-type compound semiconductor layer and an n-type compound semiconductor layer. The p-type and n-type compound semiconductors include group I-III-VI₂ compound or group I₂-II-IV-VI₄ compound. The intermediate layer has a thickness of 1 nm to 10 nm on the n-type compound semiconductor layer, and includes a compound containing one or more elements that are selected from the group consisting of ZnS, Zn(O_{α}S_{1-α}), (Zn_{β}Mg_{1-β}) (O_{α}S_{1-α}), (Zn_{β}Cd_{γ}Mg_{1-β-γ}) (O_{α}S_{1-α}), CdS, Cd(O_{α}S_{1-α}), (Cd_{β}Mg_{1-β})S, (Cd_{β}Mg_{1-β-γ}) (O_{α}S_{1-α})In₂S₃, In₂ (O_{α}S_{1-α}) CaS, Ca(O_{α}S_{1-α}), SrS, Sr(O_{α}S_{1-α}), ZnSe, ZnIn_{2-δ}Se_{4-ε}, ZnTe, CdTe, and silicon, provided that α, β, γ, δ, and ε each satisfy 0 < α <1, 0 < β < 1, 0 < γ < 1, 0 < δ < 2, 0 < ε <4, and β + γ <1.

Embodiments will be described below with reference to the drawings.

### FIRST EMBODIMENT

A photoelectric conversion element in accordance with a first embodiment includes a photoelectric conversion layer with a homojunction of p-type and n-type compound semiconductor layers, and a transparent electrode. The p-type and n-type compound semiconductor layers include group I-III-VI₂ compound or group I₂-II-IV-VI₄ compound. The transparent electrode is formed on the n-type compound semiconductor layer of the photoelectric conversion layer. The group I-III-VI₂ or the group I₂-II-IV-VI₄ includes Se as the group VI element. The n-type compound semiconductor layer has a region doped with S on the side of the transparent electrode. The first embodiment will be described in detail with reference to the drawings.

### (Photovoltaic Conversion Element)

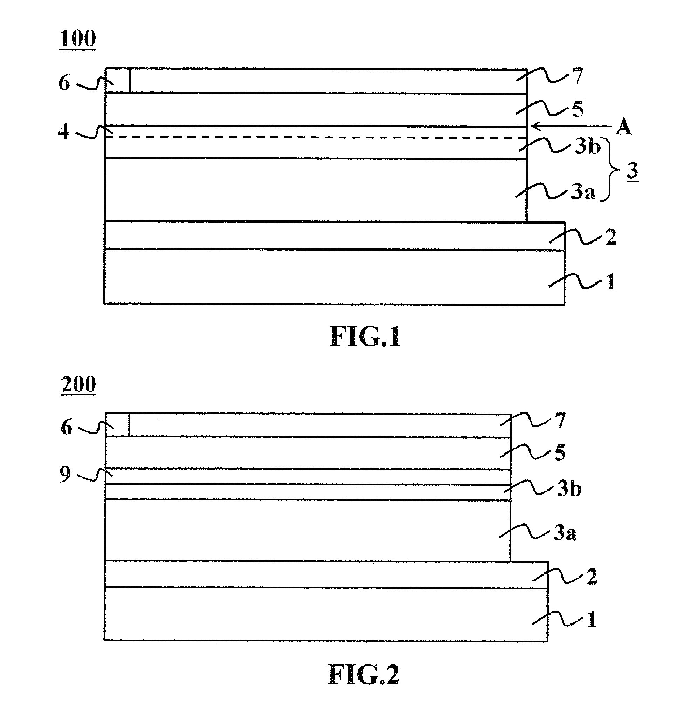

FIG. 1 is a conceptual diagram showing a photoelectric conversion element 100 in accordance with the first embodiment. The photoelectric conversion element 100 includes a substrate 1, a lower electrode 2 on the substrate 1, a photoelectric conversion layer 3, a transparent electrode 5 on the layer 3, an upper electrode 6 on the transparent electrode 5, and an antireflection film 7 on the upper electrode 6. The photoelectric conversion layer 3 includes a homojunction consisting of a p-type compound semiconductor layer 3a and an n-type compound semiconductor layer 3b. The p-type compound semiconductor layer 3a is located on the side of the lower electrode 2. The n-type compound semiconductor layer 3b is located on the side of the transparent electrode 5. The photoelectric conversion layer 3 has a region 4 doped with S on the side of the transparent electrode 5. A window layer 8 may be incorporated between the photoelectric conversion layer 3 and the transparent electrode 5. Specific examples of the photoelectric conversion element 100 specifically include solar cells.

### (Substrate)

Preferably, blue plate glass is used for the substrate 1. Alternatively, metal plates including stainless steel, Ti, and Cr, or resin such as polyimide may be used therefor.

### (Lower Electrode)

The lower electrode 2 of the embodiment includes a metal film formed on the substrate 1 for a photoelectric conversion element. Materials of the lower electrode 2 may include conductive metals including Mo and W. Preferably, Mo used for the lower electrode 2 can be formed on the substrate 1 by sputtering. The lower electrode 2 is 100 nm to 1000 nm in thickness, for example.

### (Photoelectric Conversion Layer)

The photoelectric conversion layer 3 of the embodiment is a semiconductor layer with a homojunction consisting of the p-type compound semiconductor layer 3a and the n-type compound semiconductor layer 3b. The n-type compound semiconductor layer 3b has a layered region 4 doped with S. The p-type compound semiconductor layer 3a is located on the side of the lower electrode 2 in the photoelectric conversion layer 3. The n-type compound semiconductor layer 3b on the side of the transparent electrode 4 is formed by n doping a portion of the intrinsically p-type photoelectric conversion layer 3. Chalcopyrite compounds including, for example, CIGS and CIT, which contain a group I element, a group III element, and a group VI element, may be employed for the photoelectric conversion layer 3. In addition to chalcopyrite compounds, compounds including kesterite compounds and stannite compounds may be employed for the photoelectric conversion layer 3. The compounds for the photoelectric conversion layer 3 are denoted by the chemical formulae as Cu(Al_{w}InₓGa_{1-w-x}) (S_{y}Se_{z}Te_{1-y-z})₂, Cu₂ZnSn(S_{y}Se_{1-y})₄, etc., provided that parameters w, x, y, and z satisfy 0 ≤w < 1, 0 ≤ x <1, 0 ≤ y <1, and 0 ≤ z <1, respectively, and all the parameters satisfy w + x < 1 and y + z < 1.

The photoelectric conversion layer 3 is 1000 nm to 3000 nm in thickness, for example. Preferably, the p-type compound semiconductor layer 3a is 1000 nm to 2500 nm in thickness. Preferably, the n-type compound semiconductor layer 3b is 10 nm to 800 nm in thickness. Preferably, Cu is employed as the group I element. Preferably, the group III element is one or more elements selected from the group consisting of Al, In, and Ga. In is more preferred for the reason that combining In with Ga enables it to easily acquire a targeted band gap. Te is more preferred than any other group VI elements for the reason that Te enables it to easily acquire p-type compound semiconductor. Materials of the photoelectric conversion layer 3 specifically include Cu(In,Ga)(S,Se)₂, Cu(In,Ga)(Se,Te)₂, Cu(Al,Ga,In)Se₂, Cu₂ZnSnS₄; and more specifically Cu(In,Ga)Se₂, CuInSe₂, CuInTe₂, and CuGaSe₂. Preferably, compounds, which are made up of the compounds included in the lower electrode 2 and the photoelectric conversion layer 3, are present at the interface therebetween.

The region 4 doped with S of the embodiment spreads from an interface A toward the lower electrode 2. The interface A is between the transparent electrode 5 and the n-type compound semiconductor layer 3b included in the photoelectric conversion layer 3. The region 4 doped with S overlaps the n-type compound semiconductor layer 3b, and may spread into the p-type compound semiconductor layer 3a. The region 4 doped with S reaches 100 nm or more in depth from the interface A, for example. S reaches 500 nm to 1000 nm in depth from the interface A toward the lower electrode 2. The region 4 is doped with S by an amount of S of 10¹⁵ Atom/cm³ to 10²¹ Atom/cm³. A region with a depth of 10 nm from the interface A is doped with S preferably by an amount of S of 10¹⁶ Atom/cm³ to 10²¹ Atom/cm³, and more preferably by an amount of 10¹⁹ Atom/cm³ to thereby enhance the conversion efficiency. The enhancement in the conversion efficiency by doping the region 4 with S is due to replacement of defect sites of Se, which is a group VI element, by S in the n-type compound semiconductor layer 3b. The replacement reduces interface defects to prevent carrier recombination.

When the photoelectric conversion layer 3 is formed, a p-type compound semiconductor layer is initially formed on the lower electrode 2. Subsequently, a surface region of the p-type compound semiconductor layer 3 is made to be an n-type, thereby causing the surface region to be the n-type compound semiconductor layer 3b on the side of the transparent electrode 5. Methods of forming the p-type compound semiconductor layer include sputtering, electrodeposition, vacuum deposition, selenization/sulfurization. In the vacuum deposition, temperatures of the substrate including the lower electrode are preferably set to 10°C to 600°C, and more preferably 400°C to 560°C. A too low substrate temperature degrades the crystallinity of the p-type compound semiconductor 3, and a too high substrate temperature causes crystal grains thereof to be too large, both the too low and too high substrate temperatures becoming a primary factor in a reduction in the conversion efficiency. After the p-type compound semiconductor layer is deposited, annealing may be carried out in order to control grain growth of the p-type compound semiconductor layer 3.

After the p-type compound semiconductor layer 3 is formed, a surface portion of the p-type compound semiconductor layer is made to be n-type, the surface portion on the opposite side of the lower electrode 2. Methods of the n-doping include CBC (Chemical Bath Deposition), spraying, spin coating, and vapor deposition. The n-doping employs a solution containing n-type dopant, e.g., cadmium sulfate to n dope the p-type compound semiconductor layer 3 in a liquid phase, thereby causing a surface portion of the p-type compound semiconductor layer 3 to change from "p-type" to "n-type". The change from the p-type to the n-type makes up a homojunction consisting of the p-type compound semiconductor layer 3a and the n-type compound semiconductor layer 3b, the homojunction corresponding to the photoelectric conversion layer 3. The CBC dips a component in a solution containing n-type impurities at 10 °C to 90 °C in order to n dope the p-type compound semiconductor layer 3 such that an n-type impurity concentration on the side of the transparent electrode 5 is higher than the concentration on the side of the lower electrode. The component has the p-type compound semiconductor layer 3 formed on the lower electrode layer on the substrate 1. Subsequent to the n-doping, it is preferred that the component is washed with water and dried for the next step.

The region 4 doped with S is formed by doping with S to the photoelectric conversion layer 3 from an opposite principal surface of the surface being formed the lower electrode 2. Preferably, the region doped with S is formed by a liquid phase process. Preferably, the liquid phase process employs a doping solution that contains thiourea molecules dissolved in an ammonia solution. Preferably, the doping solution contains the thiourea molecules by 1 mM to 100 mM. Preferably, the ammonia concentration of the ammonia solution is 2% to 30%. Thiourea compounds include thiourea, 1,3- diethylthiourea, and 1,3 dibutyl-2-thiourea. Thiourea is costwise the most preferable. Dissolving thiourea molecules in an ammonia solution deprotonates the thiourea molecules to dissociate S therefrom. The dissociated S is incorporated into defect sites of Se, which is a group VIb element.

The S doping is carried out by dipping a component with a photoelectric conversion layer 3 formed on a lower electrode 2 on a substrate 1 in a doping solution at 10 °C to 100 °C, preferably at about 80°C, for 1 minute to several hours. The dipping dopes the photoelectric conversion layer 3 of the component with S from the side of the opposite principal surface of the surface being formed the lower electrode. Subsequently, the doped component is taken out of the doping solution, sufficiently washed with water, and dried.

In the above description, the n doping is followed by the S doping. Alternatively, the S doping may be followed by the n doping. The sequence of the doping steps may be interchanged, provided that each of the doping steps is carried out under the same condition as described above.

A relation between the doping concentration of S and the depth profile of S in the photoelectric conversion layer 3 can be determined by SIMS (Secondary Ion Mass Spectrometry). The photoelectric conversion element is processed with a 5%-hydrochloric acid solution to remove the transparent electrode 5. Performing SIMS from the surface of the region doped with S determines the relation between the doping concentration and depth profile of S. Performing SIMS from the back surface of the region can determine the relation more accurately because of less influence from the surface roughness.

### (Transparent Electrode)

The filmy transparent electrode 5 of the embodiment transmits visible light like sunlight therethrough, and is electrically conductive. Materials of the transparent electrode 5, for example, include ZnO: Al containing 2wt% alumina (Al₂O₃) and ZnO:B doped with B dissociated from diborane. Alternatively, a window layer 8 may be provided between the transparent electrode 5 and the photoelectric conversion layer 3.

### (Window Layer)

The window layer 8 of the embodiment is an i-type (semi-insulating) layer with high resistance, and is provided between the transparent electrode 5 and the photoelectric conversion layer 3. The window layer 8 includes one or more compounds selected from the group consisting of ZnO, MgO, (ZnₐMg₁₋ₐ)O, InGa_{b}ZnₐO_{c}, SnO, InSn_{d}O_{c}, TiO₂, and ZrO₂. Preferably, the parameters a, b, c, and d satisfy 0 < a < 1, 0 < b < 1, 0 < c < 1, and 0 < d < 1. Providing such a high-resistance layer between the transparent electrode 5 and the photoelectric conversion layer 3 reduces a leak current from the n-type compound semiconductor layer 3b into the transparent electrode 5, thereby enhancing the conversion efficiency. A too thick window layer 8 is not preferred for the reason that high-resistance compounds are included in the window layer 8. A too thin window layer 8 loses the function of reducing a leak current. Thus, the window layer 8 is on average 5 nm to 100 nm in thickness.

Methods of forming the window layer 8 include a CVD (Chemical Vapor Deposition) method, spin coating, dipping, a vacuum deposition method, and sputtering. The CVD method provides an oxide film used for the window layer 8 as follows. A component having a photoelectric compound semiconductor layer 3 formed on a lower electrode layer 2 on a substrate 1 is introduced into a chamber to be heated. With the component heated, a metal-organic compound, water, etc., are introduced into the chamber to react the metal-organic compound on the n-type compound semiconductor layer 3b, thereby forming a thin oxide film on the n-type compound semiconductor layer 3b. The metal-organic compound contains at least one element selected from the group consisting of Zn, Mg, In, Ga, Sn, Ti, and Zr. The spin coating provides an oxide film used for the window layer 8 as follows. A component having a photoelectric compound semiconductor layer 3 formed on a lower electrode layer 2 on a substrate 1 is coated with a solution containing a metal-organic compound or oxide particles, which contains at least one element selected from the group consisting of Zn, Mg, In, Ga, Sn, Ti, and Zr. After the spin coating, the spin-coated component is heated and reacted in a drying machine to be provided with a thin oxide film on the photoelectric compound semiconductor layer 3. The dipping provides an oxide film used for the window layer 8 as follows. The dipping uses the same kind of solution as in the spin coating, dips a component having a photoelectric compound semiconductor layer 3 formed on a lower electrode layer 2 on a substrate 1 in a solution, the component having an exposed n-type compound semiconductor layer as a top layer. After a while, the component is lifted from the solution to be heated or reacted. Thus, the component is provided with a thin oxide film on the surface thereof. The vacuum deposition method sublimates a material of the window layer 8 by resistive heating or laser irradiation to provide an oxide film used for the window layer 8. The sputtering irradiates a material target with plasma to provide an oxide film used for the window layer 8. The spin coating and the dipping give less damage to the photoelectric conversion layer 3 than any other of the above-described methods, prevent recombination centers from being formed in the photoelectric conversion layer 3, and are therefore preferable to high conversion efficiency.

### (Upper Electrode)

The upper electrode 6 of the embodiment is a metal film formed on the transparent electrode 5. Materials of the metal film include Al and Ni. The metal film is 100 nm to 2000 nm in thickness, for example. If a sheet resistance of the transparent electrode 5 is small and a series resistance of the transparent electrode 5 is small enough to be ignored when considering the differential resistance of photoelectric convention electrode 3, the upper electrode 6 can be omitted.

### (Antireflection Film)

The antireflection film 7 of the embodiment makes it easy for light to enter the photoelectric conversion layer 3, and is formed preferably on the transparent film 5. Preferably, the antireflection film 7 includes MgF₂, for example.

### SECOND EMBODIMENT

A photoelectric conversion element in accordance with a second embodiment includes a photoelectric conversion layer, an intermediate layer, and a transparent electrode. The photoelectric conversion layer has a homojunction consisting of a p-type compound semiconductor layer and an n-type compound semiconductor layer, both including group I-III-VI₂ elements and/or group I₂-II-IV-VI₄ elements. The intermediate layer with an average thickness of 1 nm to 10 nm is formed on the n-type compound semiconductor layer, and includes a compound of Si and any one element that is selected from the group consisting of ZnS, Zn(O_{α}S_{1-α}), (Zn_{β}Mg_{1-β}) (O_{α}S_{1-α}), (Zn_{β}Cd_{γ}Mg_{1-β-γ}) (O_{α}S_{1-α}), CdS, Cd(O_{α}S_{1-α}), (Cd_{β}Mg_{1-β})S, (Cd_{β}Mg_{1-β}) (O_{α}S_{1-α})In₂S₃, In₂ (O_{α}S_{1-α}), CaS, Ca(O_{α}S_{1-α}), SrS, Sr(O_{α}S_{1-α}), ZnSe, ZnIn_{2-δ}Se_{4-ε}, ZnTe, CdTe and silicon. Preferably, the parameters of α, β, γ, δ, and ε satisfy 0 < α <1, 0 < β < 1, 0 < γ < 1, 0 < δ < 2, 0 < ε <4, and β + γ <1. A second embodiment will be described with reference to the drawings.

### (Photoelectric Conversion Element)

Fig. 2 is a conceptual diagram showing a photoelectric conversion element 200 in accordance with the second embodiment. The photoelectric conversion element 200 includes a substrate 1, a lower electrode 2 on the substrate 1, a photoelectric conversion layer 3 on the lower electrode 2, a first intermediate layer 9 on the photoelectric conversion layer 3, a transparent electrode 5 on the first intermediate layer 9, and an upper electrode 6 and an antireflection film 7 on the transparent electrode 5. The photoelectric conversion layer 3 has a homojunction consisting of p-type and n-type compound semiconductor layers 3a and 3b. The photoelectric conversion element 200 is used for a solar cell, for example.

The substrate 1, the lower electrode 2, the transparent electrode 5, the upper electrode 6, and the antireflection film 7 of the second embodiment are the same as those in the first embodiment, and will not be described repeatedly.

The photoelectric conversion layer 3 of the second embodiment differs from the photoelectric conversion layer 3 of the first embodiment only in the region 4 doped with S. The photoelectric conversion element 200 may use any one of the photoelectric conversion layers 3 with the region 4 doped with S and without the region 4 doped with S. The photoelectric conversion layer 3 without the region 4 doped with S eliminates the need for the S-doping.

### (First Intermediate Layer)

The first intermediate layer 9 includes a compound semiconductor layer provided between the photoelectric conversion layer 3 and the transparent electrode 5. The first intermediate layer 9 includes a compound containing one or more elements that are selected from the group consisting of ZnS, Zn(O_{α}S_{1-α}), (Zn_{β}Mg_{1-β}) (O_{α}S_{1-α}), (Zn_{β}Cd_{γ}Mg_{1-β-γ}) (O_{α}S_{1-α}), CdS, Cd(O_{α}S_{1-α}), (Cd_{β}Mg_{1-β})S, (Cd_{β}Mg_{1-β}) (O_{α}S_{1-α})In₂S₃, In₂(O_{α}S_{1-α}), CaS, Ca(O_{α}S_{1-α}), SrS, Sr(O_{α}S_{1-α}), ZnSe, ZnIn_{2-δ}Se_{4-ε}, ZnTe, CdTe, and silicon. It is preferred that the parameters α, β, γ, δ, and ε satisfy 0 < α <1, 0 < β < 1, 0 < γ < 1, 0 < δ < 2, 0 < ε <4, and β + γ <1. The first intermediate layer 9 need not completely cover the n-type compound semiconductor layer 3b on the side of the transparent electrode 5. For example, the first intermediate layer 9 has only to cover 50% of the n-type compound semiconductor layer 3b on the side of the transparent electrode 5. Preferably, the first intermediate layer 9 includes compounds without Cd from the view point of environmental problems. The first intermediate layer 9 having a resistivity of 1 Ωcm or more advantageously prevents a leak current due to a low-resistance portion that can be present within the first intermediate layer 9. Alternatively, the n-type compound semiconductor layer 3b may be doped with S by forming the first intermediate layer 9 originally containing S.

Providing the photoelectric conversion element with the first intermediate layer 9 enables it to enhance the conversion efficiency of the photoelectric conversion element having the photoelectric conversion layer 3 of homojunction type. Open voltage of the photoelectric conversion element having the photoelectric conversion layer 3 of homojunction type is increased to enhance the conversion efficiency by providing the photoelectric conversion element with the first intermediate layer 9. The first intermediate layer 9 works as to decrease a contact resistance between the n-type compound semiconductor layer 3b and the transparent electrode 5. Such a decrease in the contact resistance is under study. The first intermediate layer 9 is likely to serve as a transition layer between the n-type compound semiconductor layer 3b and the transparent electrode 5 to thereby reduce discontinuity of energy bands of the n-type compound semiconductor layer 3b and the transparent electrode 5 and to thereby reduce the contact resistance therebetween.

Preferably, the first intermediate layer 9 has an average thickness of 1 nm to 10 nm for enhancement of the conversion efficiency. A cross-sectional TEM (Transmission Electron Microscopy) image of the photoelectric conversion element can determine the average thickness. A photoelectric conversion layer 3 of heterojunction type needs a buffer layer, e.g., a Cds layer with a thickness of more than several tens of nm, e.g., 50 nm. The first intermediate layer 9 on the n-type compound semiconductor layer 3b is a buffer layer thinner than that in the photoelectric conversion layer 3 of heterojunction type. When a photoelectric conversion element has a photoelectric conversion layer 3 of heterojunction type with a thickness comparable to the thickness of the first intermediate layer 9, such a photoelectric conversion element undesirably reduces the conversion efficiency.

Preferably, the first intermediate layer 9 is made up of a hard film to enhance the conversion efficiency. Methods of forming the hard film include a CBD (Chemical Bath Deposition) method, a CVD method, and a PVD (Physical Vapor Deposition) method. The first intermediate layer 9 may be an oxide film, provided that the oxide film is the hard film which means a high-density film. The CBD method of depositing the first intermediate layer 9 is preferred for the reason that damaging the n-type compound semiconductor layer 3b during the deposition of the first intermediate layer 9 produces recombination centers in the n-type compound semiconductor layer 3b. A thickness of 1 nm to 10 nm is controlled by short deposition time for the first intermediate layer 9. Depositing a first intermediate layer 9 with a thickness of 5 nm requires 35 sec under conditions whereas depositing a first intermediate layer with a thickness of 60 nm requires 420 sec. How to adjust the thickness is subjected to a solution concentration of the chemical bath.

The compound (Zn_{β}Mg_{1-β})O will be described as an example material of the first intermediate layer 9. Known materials of the transparent electrode for a CIGS (Copper Indium Gallium (di)Selenide) solar cell include ZnO:Al and ZnO:B. An increase in the gallium concentration raises a CBM (Conduction Band Minimum) of CIGS to be likely to decrease the conversion efficiency. Replacing a portion of Zn with Mg adjusts the CBM of a transparent electrode to the CBM of CIGS. Furthermore, adjusting carrier concentrations enables it to form a transparent electrode just for CIGS. An optimal Mg concentration X (1-β) should vary with the composition of a CIGS solar cell, while a preferable Mg concentration ranges from 0 to 0.4. Preferably, the Mg concentration ranges from 0 to 0.3, provided that the CIGS solar cell with a Ga content of about 30% shows high conversion efficiency. The CBM and a Fermi level can be measured by UPS (Ultra-violet Photoemission Spectroscopy) and XPS (X-ray Photoemission Spectroscopy). When the photoelectric conversion layer is made up of a CIGS layer, a maximum CMB shift of about 0.2 eV may arise at the interface between an n-type compound semiconductor layer 3b included in the CIGS layer and the first intermediate layer 9.

A cross-sectional TEM image magnified 450, 000 times shows the first intermediate layer 9 as a continuous film or a discontinuous film between the n-type compound semiconductor layer 3b and the transparent electrode 5. An average thickness of the first intermediate layer 9 is determined from the thicknesses measured in a 1 cm-square region at the center of the photoelectric conversion element (panel). The composition of the first intermediate layer 9 is determined by energy dispersive X-ray spectroscopy. The volume resistivity of the first intermediate layer 9, which is formed on an insulating substrate, is measured by a four-terminal method. Thicknesses of each layer and the electrodes are determined by the same image or the like.

### (Window Layer)

The window layer 8 of the second embodiment differs from that of the first embodiment in that the window layer 8 is provided between the first intermediate layer 9 and the transparent electrode 5. The window layer 8 of the second embodiment reduces a leak current between the first intermediate layer 9 and the transparent electrode 5 to thereby enhance the conversion efficiency.

### THIRD EMBODIMENT

A photoelectric conversion element in accordance with a third embodiment includes a photoelectric conversion layer, a transparent electrode, an intermediate layer with a thickness of 1 nm to 10 nm, which is on an n-type layer between the photoelectric conversion layer and the transparent electrode, and a window layer. The photoelectric conversion layer includes a homojunction consisting of a p-type compound semiconductor layer and an n-type compound semiconductor layer, both including group I-III-VI₂ compound or group I₂-II-IV-VI₄ compound. The third embodiment will be described below with reference to the drawing.

### (Photoelectric Conversion Element)

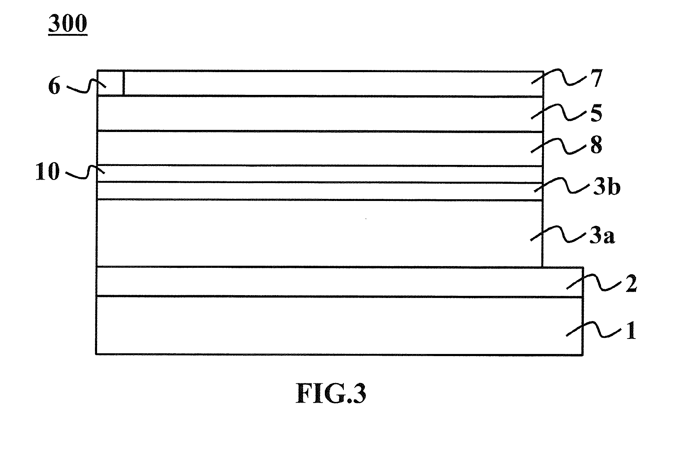

Fig. 3 is a conceptual diagram showing a photoelectric conversion element 300 of the third embodiment. The photoelectric conversion element 300 includes a substrate 1, a lower electrode 2 on the substrate 1, a photoelectric conversion layer 3 on the lower electrode 2, a second intermediate layer 10 on the photoelectric conversion layer 3, a window layer 8 on the second intermediate layer 10, a transparent electrode 5 on the window layer 8, and both an upper electrode 6 and an antireflection film 7 on the transparent electrode 5. The photoelectric conversion layer 3 has a homojunction consisting of a p-type compound semiconductor layer 3a and an n-type compound semiconductor layer 3b. The photoelectric conversion element 300 is used for a solar cell, for example.

The substrate 1, the lower electrode 2, the photoelectric conversion layer 3, the transparent electrode 5, the upper electrode 6, and the antireflection film 7 are the same as those in the second embodiment; and will not be described repeatedly. The third embodiment differs from the first and second embodiments only in that the window layer 8 is provided between the second intermediate layer and the transparent electrode 5. The first, second, and third embodiments are in common with each other regarding the first intermediate layer 9 and the second intermediate layer 10, and the common portion will not be repeated.

### (Second Intermediate Layer)

The second intermediate layer 10 of the third embodiment includes a compound semiconductor layer provided between the photoelectric conversion layer 3 and the transparent electrode 5. The second intermediate layer 10 includes a compound containing one or more elements that are selected from the group consisting of ZnS, Zn(O_{α}S_{1-α}), (Zn_{β}Mg_{1-β}) (O_{α}S_{1-α}), (Zn_{β}Cd_{γ}Mg_{1-β-γ}) (O_{α}S_{1-α}), CdS, Cd(O_{α}S_{1-α}), (Cd_{β}Mg_{1-β})S, (Cd_{β}Mg_{1-β-γ}) (O_{α}S_{1-α})In₂S₃, In₂(O_{α}S_{1-α}), CaS, Ca₂(O_{α}S_{1-α}), SrS, Sr(O_{α}S_{1-α}), ZnSe, ZnIn_{2-δ}Se_{4-ε}, ZnTe, CdTe, and silicon. Preferably, the parameters α, β, γ, δ, and ε each satisfy 0 < α <1, 0 < β < 1, 0 < γ < 1, 0 < δ < 2, 0 < ε <4, and β + γ <1. The second intermediate layer 10 need not completely cover the n-type compound semiconductor layer 3b on the side of the transparent electrode 5. For example, the second intermediate layer 10 has only to cover 50% of the n-type compound semiconductor layer 3b on the side of the transparent electrode 5.

The photoelectric conversion layer 3 includes a compound having large grains in the third embodiment. The second intermediate layer 10, i.e., a thin film, covers a small area of the photoelectric conversion layer 3 in some cases, but efficiently reduces a leak current because the second intermediate layer 10 is located between the photoelectric conversion layer 3 and the window layer 8. As a result, the second intermediate layer 10 need not so completely cover the photoelectric conversion layer 3. The coverage of the second intermediate layer 10 on the photoelectric conversion layer 3 is not so important. When a ZnS film with an average thickness of more than 50 nm, which covers the large grains completely, is formed on the photoelectric conversion layer 3; the ZnS film undesirably causes an increase in the resistance of the photoelectric conversion element to greatly reduce the conversion efficiency thereof. It is preferred that the photoelectric conversion layer 3 includes the compound having large grains also in the first and second embodiments. A cross-sectional TEM or SEM (Scanning Electron Microscope) view of the photoelectric conversion layer 3 reveals that the compound included in the photoelectric conversion layer 3 has large grains. An average maximum diameter of grains in a light-absorption layer is determined from diameters of the grains measured in a 1 cm-square region at the center of the photoelectric conversion element (panel). The diameters of the grains are measured, e.g., using a cross-sectional TEM image magnified 450,000 times. When the average maximum diameter of the grains is more than 1000 nm in the TEM image, the compound included in the photoelectric conversion layer 3 is defined as having large grains. The TEM image can also reveal how much the second intermediate layer 10 covers the photoelectric conversion layer.

The second intermediate layer 10 enables it to increase open voltage of the photoelectric conversion layer 3 having a homojunction and enhance the conversion efficiency. The second intermediate layer 10 works as to decrease a contact resistance between the n-type compound semiconductor layer 3b and the window layer 8. The second intermediate layer 10 is likely to serve as a transition layer between the n-type compound semiconductor layer 3b and the window layer 8 to thereby reduce discontinuity of energy bands of the n-type compound semiconductor layer 3b and the window layer 8 and to thereby reduce the contact resistance therebetween.

The second intermediate layer 10 is preferably 1 nm to 10 nm in thickness to enhance the conversion efficiency. More preferably, the second intermediate layer 10 is 1 nm to 5 nm in thickness. Methods of forming the hard film include a CBD method, a CVD method, vacuum evaporation, and sputtering. Damaging the n-type compound semiconductor layer 3b during the deposition of the second intermediate layer 10 produces recombination centers in the n-type compound semiconductor layer 3b. The CBD method gives less damage to the n-type compound semiconductor layer 3b, and is therefore preferred as the method of forming the second intermediate layer 10.

### (Example 1)

A filmy lower electrode simply including Mo is formed by sputtering under Ar-gas flow onto a blue plate glass measuring 25 mm long by 12.5 mm wide by 1.8 mm thick. The lower electrode is about 500 nm in thickness. Cu, In, Ga, and Se are each deposited by respective predetermined amounts on the Mo lower electrode on the blue plate glass. The total thickness is about 2200 nm. The resultant film including the lower electrode is doped with Cd, which is n-type dopant, by dipping to form an n-type semiconductor layer n-CIGS. A solution containing 0.08 mM cadmium sulfate is used for the Cd doping. The dipping is carried out at 80°C for 22 minutes while stirring the solution. Subsequent to the doping, the resultant doped film is washed with water and dried. Subsequently, the resultant film is further doped with S by dipping. A 2.5%-ammonia solution containing 50-mM thiourea is used for the S doping. The dipping for the S doping is carried out at 80°C for 22 minutes while stirring the ammonia solution to dope the n-CIGS surface with S, thereby forming a region doped with S. Subsequent to the S doping, the resultant film doped with S is washed with water and dried. Subsequently, a 50-nm thick i-ZnO layer is formed as a window layer on the side of the n-type semiconductor layer of the photoelectric conversion layer. The forming of the 50-nm thick i-ZnO layer is followed by forming a 1000-nm thick ZnO:B layer as a transparent electrode on the window layer, followed by forming a 100-nm thick MgF₂ layer as an antireflection layer on the transparent electrode, further followed by forming a 220-nm thick Al layer as an upper electrode. Thus, the photoelectric conversion element of the third embodiment is provided.

### (Comparative Example 1)

A photoelectric conversion element of a comparative example 1 is formed without S doping. Other conditions for forming the photoelectric conversion element are the same as in the example 1.

The conversion efficiency of the photoelectric conversion elements of the first example and the first comparative example were determined in the atmosphere at 20°C, using a light source simulating brightness at thirteen hundred hours. The conversion efficiency of the respective photoelectric conversion elements is cited at TABLE 1. The conversion efficiency ε is expressed as ε = Voc•sc•FF/P•100 [%], provided that Voc, Jsc, FF, and P denote open voltage, leak current density, output factor, and incident power density, respectively.

**TABLE 1**

| | Conversion Efficiency [%] | Lot |
|---|---|---|
| Example 1-1 | 13.3 | A |
| Example 1-2 | 15.5 | B |
| Example 1-3 | 13.7 | C |
| Comparative Example 1-1 | 12.3 | A |
| Comparative Example 1-2 | 14 | B |
| Comparative Example 1-3 | 12.7 | C |

The conversion efficiency of the photoelectric conversion elements having a homojunction compared in accordance with presence and absence of the region doped with S, Table 1 shows that the region doped with S enhances the conversion efficiency by up to 1.5%. The region doped with S is likely to prevent the surface recombination, thereby yielding high conversion efficiency.

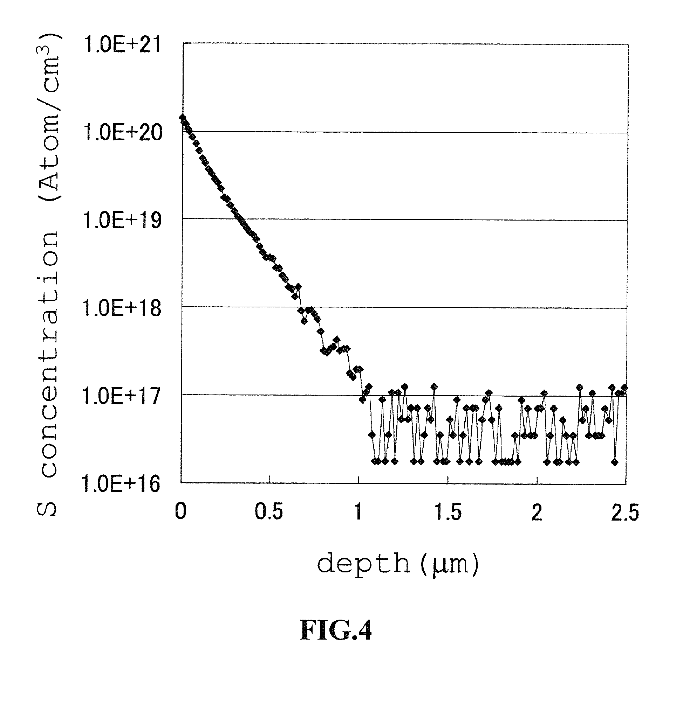

A SIMS analysis reveals that the photoelectric conversion layers of the examples are doped with S. Fig. 4 is a depth profile of S by the SIMS analysis conducted on the photoelectric conversion element of the example from the back surfaces thereof. The depth profile reveals that the CIGS layer is doped with S by a dopant amount of 10¹⁶ Atom/cm³ to 10²⁰ Atom/cm³ at a depth of 0 nm to 1000 nm. The depth profile also reveals that the photoelectric conversion layer is densely-doped with S on the side of the transparent electrode and the dopant concentration in the photoelectric conversion layer decreases toward the lower electrode.

A chalcopyrite type solar cell has Se defects near the surface of the photoelectric conversion layer of the solar cell. S-series and Te-series chalcopyrite type solar cells have S defects and Te defects, respectively. The Se defects form recombination centers to cause a reduction in the conversion efficiency. The photoelectric conversion layer of a solar cell including a homojunction is doped with S in a liquid phase to effectively enhance the conversion efficiency.

### (Example 2-1)

A p electrode including Mo only is formed by sputtering under Ar-gas flow onto a soda-lime glass measuring 25 mm long by 12.5 mm wide by 1.8 mm thick. The p electrode is 500 nm in thickness. A CIGS photoelectric conversion layer is formed on the p electrode by molecular beam epitaxy. The CIGS photoelectric conversion layer is 2 µm in thickness. Subsequently, diffusing Zn in the CIGS photoelectric conversion layer causes a side of the photoelectric conversion layer to be n type. On the side of the photoelectric conversion layer, the first intermediate layer and the transparent electrode are to be formed. The n-type region is 300 nm in depth from the surface of the photoelectric conversion layer. A first intermediate layer including Zn(O,S) with an average thickness of 2 nm is formed on the n-type region by chemical liquid deposition. A window layer including (Zn,O) is formed on the first intermediate layer, and a transparent electrode including (Zn,Mg)O:Al is subsequently formed on the window layer. An n electrode of Al and an antireflection film of MgF₂ are formed on the transparent electrode to provide a solar cell of the example 2-1.

### (Example 2-2)

A solar cell of the example 2-2 is the same as the cell of the example 2-1, except that the first intermediate layer is 4 nm in thickness on average in the example 2-2.

### (Example 2-3)

A solar cell of the example 2-3 is the same as the cell of the example 2-1, except that the first intermediate layer is 6 nm in thickness on average in the example 2-3.

### (Example 2-4)

A solar cell of the example 2-4 is the same as the cell of the example 2-1, except that the first intermediate layer is 8 nm in thickness on average in the example 2-4.

### (Example 2-5)

A solar cell of the example 2-5 is the same as the cell of the example 2-1, except that the first intermediate layer is 10 nm in thickness on average in the example 2-5.

### (Example 2-6)

A solar cell of the example 2-6 is the same as the cell of the example 2-1, except that the first intermediate layer includes (Zn,Mg)O in the example 2-6.

### (Example 2-7)

A solar cell of the example 2-7 is the same as the cell of the example 2-6, except that the first intermediate layer is 4 nm in thickness on average in the example 2-6.

### (Example 2-8)

A solar cell of the example 2-8 is the same as the cell of the example 2-6, except that the first intermediate layer is 6 nm in thickness on average in the example 2-8.

### (Example 2-9)

A solar cell of the example 2-9 is the same as the cell of the example 2-6, except that the first intermediate layer is 8 nm in thickness on average in the example 2-9.

### (Example 2-10)

A solar cell of the example 2-10 is the same as the cell of the example 2-6, except that the first intermediate layer is 10 nm in thickness on average in the example 2-10.

### (Comparative Example 2-1)

A solar cell of a comparative example 2-1 is the same as the cell of the example 2-1, except that the comparative example 2-1 lacks the first intermediate layer.

### (Comparative Example 2-2)

A solar cell of a comparative example 2-2 is the same as the cell of the example 2-1, except that the first intermediate layer is 12 nm in thickness on average in the comparative example 2-2.

### (Comparative Example 2-3)

A solar cell of a comparative example 2-3 is the same as the cell of the example 2-6, except that the first intermediate layer is 12 nm in average thickness in the comparative example 2-3.

### (Reference Example 2-1)

A solar cell of a reference example 2-1 is the same as the cell of the example 2-1, except that the first intermediate layer includes CdS in the reference example 2-1.

### (Reference Example 2-2)

A solar cell of a reference example 2-2 is the same as the cell of the reference example 2-1, except that the first intermediate layer is 4 nm in average thickness in the reference example 2-2.

### (Reference Example 2-3)

A solar cell of a reference example 2-3 is the same as the cell of the reference example 2-1, except that the first intermediate layer is 6 nm in average thickness in the reference example 2-3.

### (Reference Example 2-4)

A solar cell of a reference example 2-4 is the same as the cell of the reference example 2-1, except that the first intermediate layer is 8 nm in average thickness in the reference example 2-4.

### (Reference Example 2-5)

A solar cell of a reference example 2-5 is the same as the cell of the reference example 2-1, except that the first intermediate layer is 10 nm in average thickness in the reference example 2-5.

### (Reference Example 2-6)

A solar cell of a reference example 2-6 is the same as the cell of the reference example 2-1, except that the first intermediate layer is 12 nm in average thickness in the reference example 2-6.

### (Comparative Example 2-4)

A solar cell of a comparative example 2-4 is the same as the cell of the example 2-1, except that a photoelectric conversion layer is not made to be n-type and a 30-nm thick CdS layer is deposited on the photoelectric conversion layer by chemical liquid deposition to thereby form a photoelectric conversion element of heterojunction type in the comparative example 2-4.

### (Comparative Example 2-5)

A solar cell of a comparative example 2-5 is the same as the cell of the comparative example 2-4, except that the CdS layer is 50 nm in comparative example 2-5.

### (Comparative Example 2-6)

A solar cell of a comparative example 2-6 is the same as the cell of the comparative example 2-4, except that the CdS layer is 70 nm in comparative example 2-6.

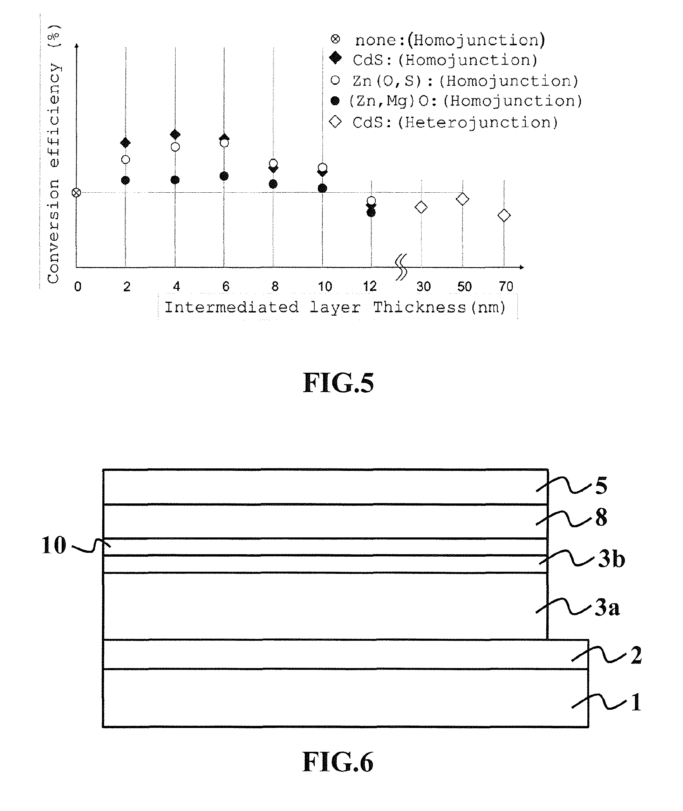

The conversion efficiency of the photoelectric conversion elements is determined in accordance with the examples, the reference examples, and the comparative examples. Fig. 5 is a graph showing changes in the conversion efficiency of the solar cells of various junction types. The conversion efficiency ε is expressed as ε = Voc•Jsc•FF/P•100 [%]. In Fig. 5, the conversion efficiency is shown as ratios of the efficiency of the solar cells to the efficiency of the solar cell without the first intermediate layer. The conversion efficiency is determined at room temperature using a solar simulator with a light source of AM1.5 and a prober.

Fig. 5 reveals the following. The conversion efficiency of the photoelectric conversion elements is enhanced by incorporating a thin intermediate layer in the elements. In a thickness of 2 nm to 10 nm, the conversion efficiency is similarly enhanced while increasing the thickness of the first intermediate layer, independently of compounds included in the first intermediate layer. In accordance with the embodiment, the presence of the first intermediate layer clearly yields high conversion efficiency.

### (Example 3-1)

Fig. 6 shows a photoelectric conversion element of an example 3-1, which is a portion of the photoelectric conversion element without the layer 7 or the electrode 6 in Fig. 3. A glass substrate 1 includes a Mo electrode (500 nm in thickness) deposited thereon by sputtering. The p-type layer 3a of Cu(In_{0.7}Ga_{0.3} (S_{0.05}Se_{0.95}))₂ is deposited by sputtering a Cu(In_{0.7}Ga_{0.3}) target, followed by selenization/sulfurization to adjust the composition of the p-type layer 3a to a prescribed composition. A CBD method causes a surface portion of the p-type layer 3a to be an n-type by doping the surface portion with Cd, i.e., n-type dopant. The diffusion length of Cd, i.e., the thickness of the n-type layer 3b, is determined to be 70 nm in depth by SIMS analysis. A second intermediate layer 10 of CdS with an average thickness of 2 nm is formed on the n-type layer 3b by a CBD method. A window layer 8 of ZnO with an average thickness of 25 nm is further formed on the second intermediate layer 10 by spin coating. After that, a transparent electrode 5 of ZnO:Al is formed by sputtering. An antireflection layer is not shown. The photoelectric conversion element of the example 3-1 differs from the photoelectric conversion element of Fig. 3 in that the example 3-1 lacks the Al electrode, instead of which element isolation of the photoelectric conversion element formed on the glass is carried out with a scriber so that the transparent electrode is short-circuited to the Mo electrode to be series-connected.

When the photoelectric conversion element of the example 3-1 is irradiated with quasi-solar light, the photoelectric conversion element shows open voltage of 13.6 V and conversion efficiency of 18%. The open voltage and the conversion efficiency are determined using a solar simulator with a light source of AM1.5 and a prober.

### (Comparative Example 3-1)

A photoelectric conversion element of a comparative example 3-1 is the same as the cell of the example 3-1, except that the comparative example 3-1 lacks the second intermediate layer. The photoelectric conversion element of the comparative example 3-1 shows open voltage of 12.4 V and conversion efficiency of 16%. The second intermediate layer is likely to give rise to difference in the open voltage and the conversion efficiency.

### (Example 3-2)

A photoelectric conversion element of an example 3-2 is an example embodying the element shown in Fig. 3. A glass substrate 1 includes a Mo electrode (500 nm in thickness) as a lower electrode deposited thereon by sputtering. The p-type layer 3a of Cu₂ZnSn₄ is deposited by sputtering a CuZnSn target, followed by selenization/sulfurization to adjust the composition of the p-type layer 3a to Cu₂ZnSnS₄. A CBD method causes a surface portion of the p-type layer 3a to be an n-type by doping the surface portion with Cd, i.e., n-type dopant. The diffusion length of Cd, i.e., the thickness of the n-type layer 3b, is determined to be 100 nm in depth by SIMS analysis. A second intermediate layer 10 of ZnS with an average thickness of 2 nm is formed on the n-type layer 3b by a CBD method. A window layer 8 of ZnO:Al with an average thickness of 20 nm is further formed on the second intermediate layer 10 by spin coating. An antireflection layer is not shown. The photoelectric conversion element of the example 3-2 differs from the photoelectric conversion element of Fig. 6 in that the example 3-2 lacks the Al electrode, instead of which element isolation of the photoelectric conversion element formed on the glass is carried out with a scriber so that the transparent electrode is short-circuited to the Mo electrode to be series-connected.

When the photoelectric conversion element of the example 3-2 is irradiated with quasi-solar light, the photoelectric conversion element shows open voltage of 12.6 V and conversion efficiency of 14%.

### (Comparative Example 3-2)

A photoelectric conversion element of a comparative example 3-2 is the same as the cell of the example 3-1, except that the comparative example 3-2 lacks the second intermediate layer. When the photoelectric conversion element of the comparative example 3-2 is irradiated with quasi-solar light in the same way, the photoelectric conversion element shows open voltage of 11.2 V and conversion efficiency of 10%. The second intermediate layer is likely to give rise to difference in the open voltage and the conversion efficiency.

### (Example 3-3)

A photoelectric conversion element of an example 3-3 is the same as the cell of the example 3-1, except that the comparative example 3-3 employs ZnS for the second intermediate layer. When the photoelectric conversion element of the example 3-3 is irradiated with quasi-solar light in the same way, the photoelectric conversion element shows open voltage of 14 V and conversion efficiency of 18.5%.

### (Example 3-4)

A photoelectric conversion element of an example 3-4 is the same as the cell of the example 3-1, except that the example 3-4 employs In₂S₃ for the second intermediate layer. When the photoelectric conversion element of the example 3-4 is irradiated with quasi-solar light in the same way, the photoelectric conversion element shows open voltage of 13.5 V and conversion efficiency of 17.7%.

### (Example 3-5)

A photoelectric conversion element of an example 3-5 is the same as the cell of the example 3-1 with the second intermediate layer 2 nm thick, except that the second intermediate layers in photoelectric conversion elements of the example 3-5 have various thicknesses of 5 nm, 8 nm, 10 nm, 15 nm, and 50 nm. The thicknesses are controlled by adjusting reaction time in the CBD method. The average thicknesses of the second intermediate layers of the example 3-1, the example 3-5, and the comparative example 3-1 are cited in TABLE 2 regarding open voltage and conversion efficiency.

**TABLE 2**

| Average Thickness of Second Intermediate Layer [nm] | Open Voltage [V] | Conversion Efficiency [%] |
|---|---|---|
| 0 | 12.5 | 16.0 |
| 2 | 13.6 | 18.0 |
| 5 | 13.5 | 17.8 |
| 8 | 13.0 | 17.0 |
| 10 | 12.5 | 16.3 |
| 15 | 12.0 | 15.6 |
| 50 | 10.3 | 13.5 |

Incorporating a thin second intermediate layer enhances conversion efficiency of the photoelectric conversion element. The conversion efficiency increases in the thickness range of 2 nm to 10 nm. Most of the elements with the second intermediate layers have higher conversion efficiency than the element without the second intermediate layer.

### (Example 3-6)

Photoelectric conversion elements of an example 3-5 are prepared as to have window layers with thicknesses of 0 nm (no window layer), 2 nm, 5 nm, 10 nm, 25 nm, 50 nm, 100 nm, 200 nm by adjusting rotation speed and solution concentration in the spin coating, provided that the second intermediate layers have an average thickness of 2 nm by adjusting reaction time in the CBD method. Open voltage, fill factors, and conversion efficiency of the prepared photoelectric conversion elements are cited in TABLE 3. The open voltage and the conversion efficiency are determined at room temperature using a solar simulator with a light source of AM1.5 and a prober.

**TABLE 3**

| Average Thickness of Window Layer [nm] | Open Voltage [V] | Fill Factor [%] | Conversion Efficiency [%] |
|---|---|---|---|
| 0 | 13.6 | 73 | 18.0 |
| 2 | 13.6 | 73 | 18.0 |
| 5 | 13.7 | 74 | 18.4 |
| 10 | 14.0 | 75 | 19.0 |
| 25 | 14.4 | 77 | 20.1 |
| 50 | 13.9 | 75 | 18.9 |
| 100 | 13.7 | 74 | 18.3 |
| 200 | 13.0 | 71 | 16.7 |

Incorporating a window layer enhances the conversion efficiency. The conversion efficiency increases in the thickness range from 5 nm to 100 nm. The window layer 8 clearly reduces a leak current between the second intermediate layer 10 and the transparent electrode 5 to thereby contribute to the enhancement of the conversion efficiency.

Throughout the specification, some elements are denoted by chemical symbols. While a certain embodiment of the invention has been described, the embodiment has been presented by way of examples only, and is not intended to limit the scope of the inventions. Indeed, the novel elements and apparatuses described herein may be embodied in a variety of other forms; furthermore, various omissions, substitutions and changes in the form of the methods described herein may be made without departing from the spirit of the invention. The accompanying claims and their equivalents are intended to cover such forms or modifications as would fall within the scope and spirit of the invention.

## Claims

1. An element, which is a photoelectric conversion element comprising:
- a photoelectric conversion layer having a homojunction of a p-type compound semiconductor layer and an n-type compound semiconductor layer, the p-type and n-type compound semiconductors including group I-III-VI₂ compound or group I₂-II-IV-VI₄ compound;
- a transparent electrode;
- an intermediate layer provided between the n-type compound semiconductor layer and the transparent electrode, the intermediate layer having an average thickness of 1-10 nm; and
- a window layer provided between the intermediate layer and the transparent electrode.

2. The element of claim 1, wherein the intermediate layer includes compounds selected from ZnS, Zn(O_{α}S_{1-α}), (Zn_{β}Mg_{1-β}) (O_{α}S_{1-α}), (Zn_{β}Cd_{γ}Mg_{1-β-γ}) (O_{α}S_{1-α}), CdS, Cd(O_{α}S_{1-α}), (Cd_{β}Mg_{1-β})S, (Cd_{β}Mg_{1-β-γ}) (O_{α}S_{1-α}) In₂S₃, In₂(O_{α}S_{1-α}), CaS, Ca(O_{α}S_{1-α}), SrS, Sr(O_{α}S_{1-α}), ZnSe, ZnIn_{2-δ}Se_{4-ε}, ZnTe, CdTe, and silicon, wherein 0 < α < 1, 0 < β < 1, 0 < γ < 1, 0 < β < 2, 0 < ε < 4, and (+γ) < 1.

3. The element of claim 1 or 2, wherein the window layer is thicker on average than the intermediate layer.

4. The element of any of claims 1-3, wherein the window layer is electrically intrinsic, and includes compounds selected from ZnO, MgO, (Zn_{α}Mg_{1-α})O, InGa_{b}ZnₐO_{c}, SnO, InSn_{d}O_{c}, TiO₂, and ZrO₂, wherein 0 < a < 1, 0 < b < 1, 0 < c < 1, and 0 < d < 1.

5. The element of any of claims 1-4, wherein
- the group I-III-VI₂ compound or the group I₂-II-IV-VI₄ compound includes Se as a group VI element; and
- the n-type compound semiconductor layer includes a region doped with S on a side of the transparent electrode.

6. An element, which is a photoelectric conversion element comprising:
- a photoelectric conversion layer having a homojunction of a p-type compound semiconductor layer and an n-type compound semiconductor layer, the p-type and n-type compound semiconductor layers including group I-III-VI₂ compound or group I₂-II-IV-VI₄ compound, each including Se as a group VI element;
- a transparent electrode provided on the n-type compound semiconductor layer,
wherein the n-type compound semiconductor layer includes a region doped with S on a side of the transparent electrode.

7. The element of claim 6, wherein the amount of S in the region doped with S is 10¹⁵-10²¹ Atom/cm³.

8. The element of claim 6 or 7, wherein the amount of S near an interface between the n-type compound semiconductor layer and the transparent electrode is 10¹⁶-10²¹ Atom/cm³.

9. The element of any of claims 6-8, wherein the region doped with S has a depth of 500 nm from the interface toward the p-type compound semiconductor layer.

10. The element of any of claims 6-9, wherein the region doped with S has a depth of 1000 nm from the interface toward the p-type compound semiconductor layer.

11. An element, which is a photoelectric conversion element comprising:
- a photoelectric conversion layer having a homojunction of a p-type compound semiconductor layer and an n-type compound semiconductor layer, the p-type and n-type compound semiconductor layers including group I-III-VI₂ compound or group I₂-II-IV-VI₄ compound;
- an intermediate layer with a thickness of 1-10 nm on the n-type compound semiconductor layer includes a compound containing one or more elements that are selected from ZnS, Zn(O_{α}S_{1-α}), (Zn_{β}Mg_{1-β}) (O_{α}S_{1-α}), (Zn_{β}Cd_{γ}Mg_{1-β-γ}) (O_{α}S_{1-α}), CdS, Cd(O_{α}S_{1-α}), (Cd_{β}Mg_{1-β}) S, (Cd_{β}Mg_{1-β-γ})(O_{α}S_{1-α})In₂S₃, In₂(O_{α}S_{1-α}), CaS, Ca(O_{α}S_{1-α}), SrS, Sr(O_{α}S_{1-α}), ZnSe, ZnIn_{2-δ}Se_{4-ε}, ZnTe, CdTe, and silicon, wherein 0 < α < 1, 0 < β < 1, 0 < γ < 1, 0 < δ < 2, 0 < ε < 4, and (β+γ) < 1; and
- a transparent electrode on the intermediate layer.

12. The element of claim 11, wherein the intermediate layer has volume resistivity of ≥ 1 Ωcm.

13. The element of claim 11 or 12, wherein the intermediate layer covers more than 50% of a surface of the n-type compound semiconductor layer.

14. A solar cell comprising the photoelectric conversion element of any of claims 1-13.
